# EUROPEAN PATENT APPLICATION

(11) **EP 0 911 637 A2**
(43) Date of publication of application: **28.04.1999**
(21) Application number: 98308613.3
(22) Date of filing: 21.10.1998
(51) Int. Cl.: G01R 1/07, G01R 13/34

(54) **Signal processing circuit for electro-optic probe**

(30) Priority: 22.10.1997 JP 290131/97
(71) Applicant: ANDO ELECTRIC CO., LTD., Tokyo 144 (JP); NIPPON TELEGRAPH AND TELEPHONE CORPORATION, Tokyo 160 (JP)
(72) Inventor: Takeuchi, Nobuaki, c/o Ando Electric Co. Ltd., Ota-ku, Tokyo (JP); Yanagisawa, Yoshiki, c/o Ando Elec. Co. Ltd., Ota-ku, Tokyo (JP); Kikuchi, Jun, c/o Ando Elec. Co. Ltd., Ota-ku, Tokyo (JP); Endou, Yoshio ,c/o Ando Elec. Co. Ltd., Ota-ku, Tokyo (JP); Shinagawa, Mitsuru, Nippon Telegr. and Tel. Corp., Shinjuku-ku, Tokyo (JP); Nagatsuma, Tadao, Nippon Telegr. and Tel. Corp., Shinjuku-ku, Tokyo (JP); Matsuhiro, Kazuyoshi, Tokyo (JP)
(74) Representative: Read, Matthew Charles

(57) **Abstract**

A signal processing circuit is provided for an electro-optic probe, which is used to perform testing of a printed-circuit board for high-speed processing. Herein, a head portion of the electro-optic probe is mainly constructed by an electro-optic crystal (e.g., Bi₁₂SiO₂₀), a multilayer dielectric mirror and a metal pin. When the metal pin is brought into contact with a signal line laid on the printed-circuit board, an electric field is caused to occur at the metal pin and is connected with the electro-optic crystal. Due to Pockel's effect, a birefringence ratio of the electro-optic crystal is varied in response strength of the connected electric field. So, when a laser beam is incident on the electro-optic crystal, it is changed in polarization and is reflected by the multilayer dielectric mirror. The reflected laser beam is split into two beams, which are then converted to electric signals. An amplification circuit performs differential amplification on the electric signals output from the electro-optic probe. An analog-to-digital conversion circuit converts output of the amplification circuit to digital data. In order to improve amplification efficiency for output of the electro-optic probe, an optimum frequency band is set to the amplification circuit while an optimum sampling timing is set to the analog-to-digital conversion circuit. The optimum frequency band and optimum sampling timing are determined such that output of the analog-to-digital conversion circuit becomes maximal.

## Description

### BACKGROUND OF THE INVENTION

### Field of the Invention

This invention relates to signal processing circuits that process signals output from electro-optic probes used for testing of high-speed processing systems.

This application is based on Patent Application No. Hei 9-290131 filed in Japan, the content of which is incorporated herein by reference.

### Description of the Related Art

In accordance with tendencies in increases of processing speeds of information communication systems in these days, it is demanded to provide extremely high-speed hardware used for those systems. As high-impedance probes that are required for testing of printed-circuit boards of high-speed processing, the recent technology develops electro-optic probes (or electric-optic sampling probe, abbreviated by EOS).

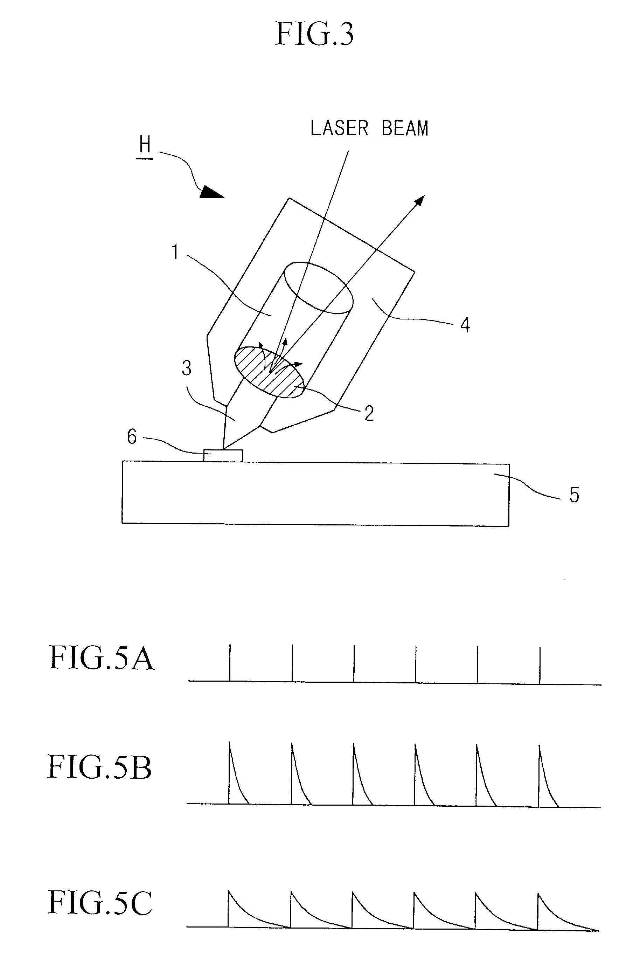

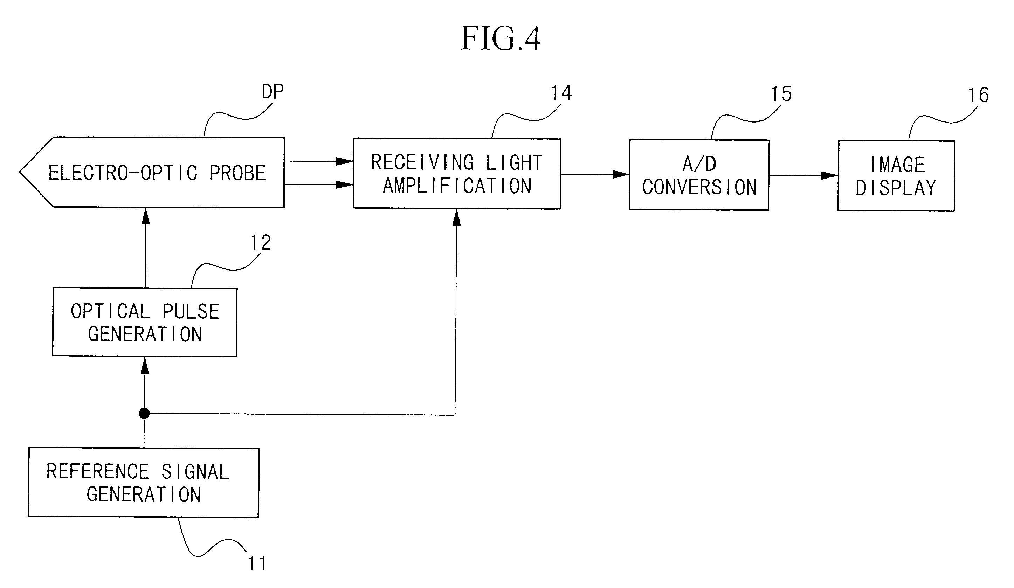

FIG. 3 shows an example of a simplified construction of an electro-optic probe. Particularly, FIG. 3 shows a head portion H of the electro-optic probe. Herein, an electro-optic crystal 1 is made of electro-optic material such as BSO (i.e., Bi₁₂SiO₂₀). A multilayer dielectric mirror 2 is formed on a lower surface of the electro-optic crystal 1 by vapor deposition, wherein it is capable of reflecting laser beams input thereto. In addition, a metal pin 3 is attached to the lower surface of the electro-optic crystal 1. The aforementioned electro-optic crystal 1 and the metal pin 3 are incorporated in an insulator 4.

When the metal pin 3 of the head portion H is brought into contact with a signal line 6 laid on a board 5, an electric field is caused to occur due to signals transmitted through the wiring, so the electric field is connected with the electro-optic crystal 1. Due to primary electro-optic effect such as Pockel's effect, the electro-optic crystal 1 is brought into a state that a birefringence ratio thereof is varied in response to strength of the "connected" electric field. So, by introducing laser beams into the electro-optic crystal 1 under such a state, the laser beams are changed in polarization states. The laser beams subjected to changes in polarization states are reflected by the multilayer dielectric mirror 2 and are then introduced to a polarization detection optical system (not shown) provided inside of the probe.

In the polarization detection optical system, the laser beam output from the head portion H is split into polarized components, which are perpendicular with each other in orientations, by a polarization beam splitter. Then, the polarized components of the laser beam are respectively converted to electric signals by photodiodes. The electric signals are forwarded to a signal processing circuit.

FIG. 4 is a block diagram showing an example of a configuration of the signal processing circuit. In FIG. 4, a reference signal generation circuit 11 generates pulse signals of a constant frequency, which are supplied to an optical pulse generation circuit 12. The optical pulse generation circuit 12 uses a semiconductor laser to convert the pulse signals to laser beam pulses (i.e., optical pulses), which are then forwarded to a head portion H (see FIG. 3) of an electro-optic probe DP via an optical fiber amplifier, an optical bandpass filter and a polarization controller, all of which are not shown in FIG. 4. Those optical pulses pass through the electro-optic crystal 1 of the head portion H. Thereafter, they are converted to electric signals by the aforementioned polarization detection optical system of the electro-optic probe DP. The electric signals are input to a receiving light amplification circuit 14.

The receiving light amplification circuit 14 performs differential amplification on output signals of the electro-optic probe DP. Output of the receiving light amplification circuit 14 is forwarded to an analog-to-digital conversion circuit (abbreviated by "A/D conversion circuit") 15. Based on the pulse signals output from the reference signal generation circuit 11, the AID conversion circuit 15 performs sampling with respect to an output of the receiving light amplification circuit 14 which is given at the timing when a prescribed time elapsed from the leading-edge timing of the optical pulse. Thus, the A/D conversion circuit 15 converts analog signals, corresponding to results of the sampling, to digital data, which are then forwarded to an image display circuit 16. The image display circuit 16 performs image display processing based on the output of the A/D conversion circuit 15.

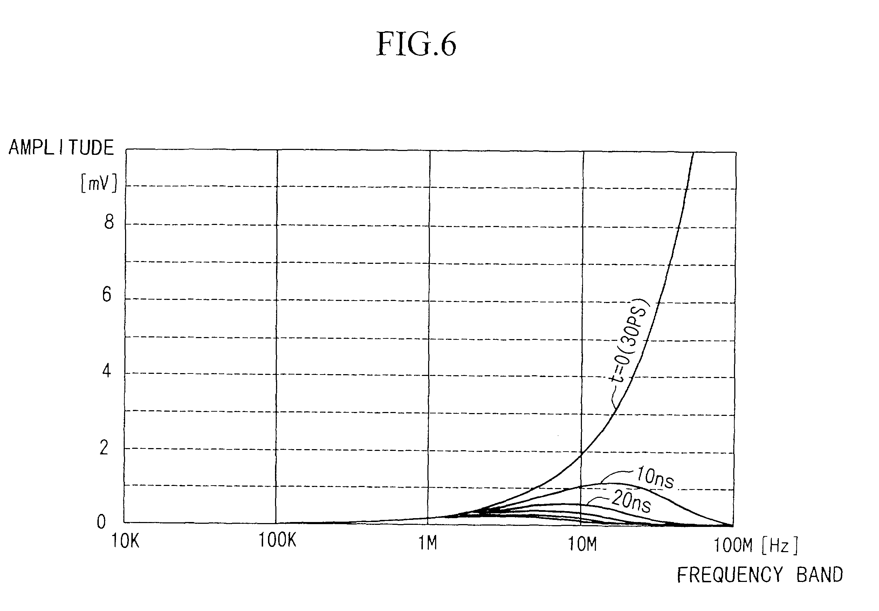

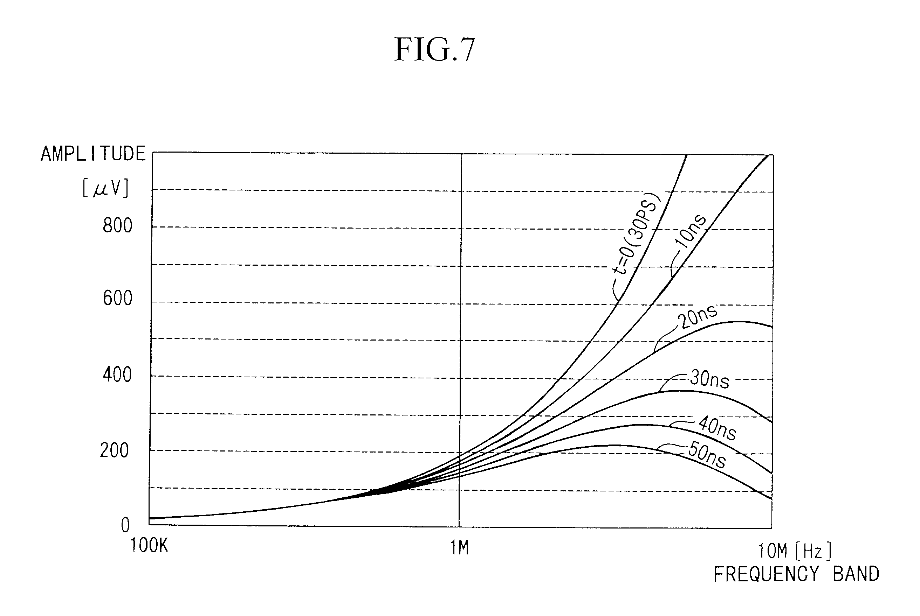

By the way, the output signals of the receiving light amplification circuit 14 greatly differ in waveforms and levels with respect to frequency bands respectively. FIG. 5A shows an example of waveforms of optical pulses. Based on the above optical pulses, the receiving light amplification circuit 14 creates output waveforms, which are shown in FIG. 5B, for example. FIG. 5C shows output waveforms of another type of the receiving light amplification circuit whose frequency band is narrow as compared with the above receiving light amplification circuit 14. Output values of the A/D conversion circuit 15 greatly differ with respect to sampling points as well as the frequency bands to be employed by the receiving light amplification circuit 14. FIG. 6 is a graph showing curves representing relationships between frequency bands of the receiving light amplification circuit 14 and outputs (mV) of the A/D conversion circuit 15, wherein sampling points of the A/D conversion circuit 15 are used as parameters. FIG. 7 is an enlarged view of a selected part of the graph of FIG. 6. Those curves are produced using optical pulses whose pulse width is 30 picoseconds (ps), while they are produced respectively in response to delay times, which are measured from the optical pulse at the sampling point and which range between 0-50 nanoseconds (ns). It is clearly observed from the graph(s) that the output values of the A/D conversion circuit 15 are varied in response to the sampling points. In addition, the output values are varied in response to the frequency band of the receiving light amplification circuit 14 as well. Incidentally, the graphs merely show theoretical values, so actual output values of the A/D conversion circuit 15 are differed from the theoretical values in response to the causes such as response speeds of circuit elements.

The aforementioned signal processing circuit of the electro-optic probe is not at all designed in consideration of differences of the output values of the A/D conversion circuit based on the aforementioned frequency band of the receiving light amplification circuit. Therefore, the conventional technology suffers from a problem that amplification efficiency is not so good.

### SUMMARY OF THE INVENTION

It is an object of the invention to provide a signal processing circuit that is capable of improving amplification efficiency for output of an electro-optic probe.

A signal processing circuit of this invention is provided for an electro-optic probe, which is used to perform testing of a printed-circuit board for high-speed processing. Herein, a head portion of the electro-optic probe is mainly constructed by an electro-optic crystal, a multilayer dielectric mirror and a metal pin. When the metal pin is brought into contact with a signal line laid on the printed-circuit board, an electric field is caused to occur around the metal pin and is connected with the electro-optic crystal. Due to Pockel's effect, a birefringence ratio of the electro-optic crystal is varied in response strength of the connected electric field. So, when a laser beam is incident on the electro-optic crystal, it is changed in polarization and is reflected by the multilayer dielectric mirror. The reflected laser beam is split into two beams, which are then converted to electric signals.

An amplification circuit performs differential amplification on the electric signals output from the electro-optic probe. An analog-to-digital conversion circuit converts output of the amplification circuit to digital data. In order to improve amplification efficiency for output of the electro-optic probe, an optimum frequency band is set to the amplification circuit while an optimum sampling timing is set to the analog-to-digital conversion circuit. The optimum frequency band and optimum sampling timing are determined such that output of the analog-to-digital conversion circuit becomes maximal.

### BRIEF DESCRIPTION OF THE DRAWINGS

These and other objects, aspects and embodiment of the present invention will be described in more detail with reference to the following drawing figures, of which:
FIG. 1 is a block diagram showing a configuration of a signal processing circuit for an electro-optic probe in accordance with embodiment of the invention;
FIG. 2 is a graph showing relationships between frequency bands of a receiving light amplification circuit and S/N ratios in output of an analog-to-digital conversion circuit shown in FIG. 1;
FIG. 3 shows an example of construction of a head portion of the electro-optic probe;
FIG. 4 is a block diagram showing an example of a configuration of the signal processing circuit for the electro-optic probe;
FIG. 5A shows a string of optical pulses;
FIG. 5B and FIG. 5C show examples of output waveforms of a receiving light amplification circuit shown in FIG. 4 in response to the optical pulses;
FIG. 6 is a graph showing relationships between frequency bands of the receiving light amplification circuit and outputs of an analog-to-digital conversion circuit shown in FIG. 4; and
FIG. 7 is an enlarged view of a selected part of the graph of FIG. 6.

### DESCRIPTION OF THE PREFERRED EMBODIMENT

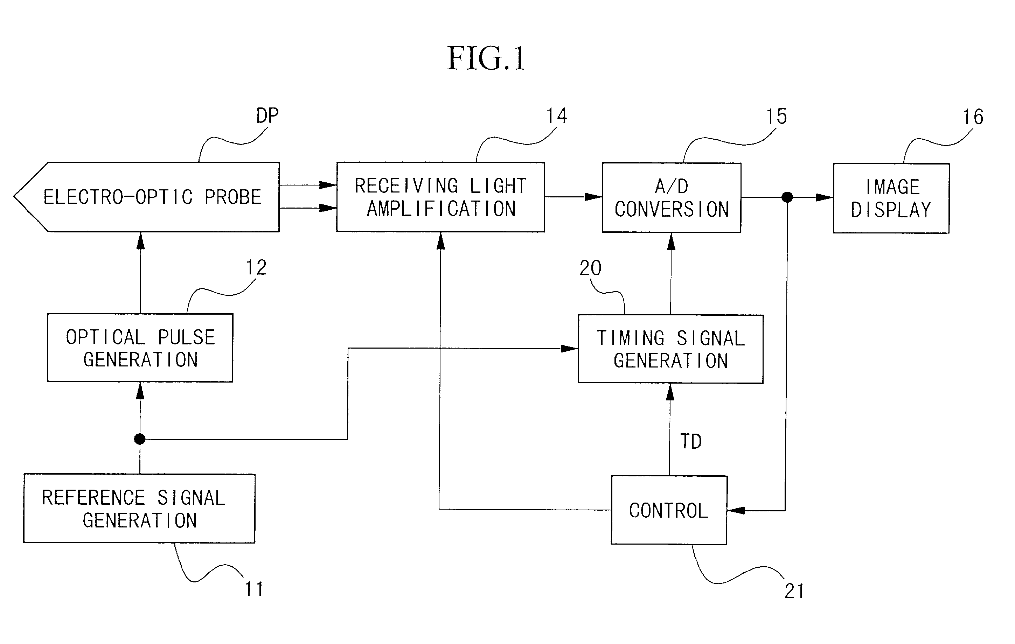

FIG. 1 is a block diagram showing a configuration of a signal processing circuit for an electro-optic probe in accordance with the preferred embodiment of the invention. In FIG. 1, parts equivalent to those of FIG. 4 will be designated by the same numerals, hence, the description thereof will be omitted. The configuration of FIG. 1 is characterized by further providing a timing signal generation circuit 20 and a control circuit 21 in addition to the circuit elements included in the configuration of FIG. 4. Herein, the timing signal generation circuit 20 delays the pulse signal (i.e., reference pulses) output from the reference signal generation circuit 11 in response to a delay time corresponding to timing data TD output from the control circuit 21. Thus, the delayed reference pulses are forwarded to the AID conversion circuit 15 as sampling pulses.

The control circuit 21 controls the sampling timing of the A/D conversion circuit 15 as well as the frequency band of the receiving light amplification circuit 14. Hereinafter, operation of the control circuit 21 will be described in detail.

In determination of the sampling timing of the A/D conversion circuit 15, the control circuit 21 produces timing data TD designating a sampling timing of 5 nanoseconds, for example. The timing data TD are supplied to the timing signal generation circuit 20. In response to the timing data TD, the timing signal generation circuit 20 delays the foregoing reference pulse by 5 nanoseconds, so that delayed reference pulse is forwarded to the A/D conversion circuit 15. Thus, the AID conversion circuit 15 performs sampling with respect to output of the receiving light amplification circuit 14 at the timing that is delayed from the timing of the optical pulse by 5 nanoseconds. Therefore, the A/D conversion circuit 15 converts such an output of the receiving light amplification circuit 14 to digital data, which are output therefrom. The control circuit 21 writes the digital data, output from the A/D conversion circuit 15, into an internal memory thereof. Next, the control circuit 21 outputs timing data TD designating 10 nanoseconds. In response to the above timing data TD, the timing signal generation circuit 20 delays the reference pulse by 10 nanoseconds, so that the delayed reference pulse is forwarded to the A/D conversion circuit 15. Thus, the A/D conversion circuit 15 performs sampling with respect to output of the receiving light amplification circuit 14 at the timing that is delayed from the timing of the optical pulse by 10 nanoseconds. Therefore, the A/D conversion circuit 15 converts such an output of the receiving light amplification circuit 14 to digital data, which are output therefrom. The control circuit 21 writes the digital data into the internal memory thereof.

Thereafter, the aforementioned operations are repeated. As a result, the internal memory of the control circuit 21 stores multiple digital data, which are provided with respect to the sampling timings of 5, 10, ..., 50 nanoseconds respectively. Then, the control circuit 21 performs comparison among them so as to detect the sampling timing corresponding to the digital data whose value is the largest among the multiple digital data. Next, the control circuit 21 outputs the timing data TD designating the detected sampling timing to the timing signal generation circuit 20. Thereafter, the AID conversion circuit 15 performs analog-to-digital conversion based on such sampling timing designated by the above timing data TD.

Next, the control circuit 21 controls the receiving light amplification circuit 14 to sequentially change its frequency band. Every time the frequency band is changed, the control circuit 21 writes digital data output from the A/D conversion circuit 15 into the internal memory thereof. At a time to complete collection of a predetermined number of digital data, the control circuit 21 performs comparison among the digital data. Through the comparison, the control circuit 21 detects a frequency band that provides digital data whose value is the largest among the predetermined number of digital data. Thus, the control circuit 21 sets the detected frequency band to the receiving light amplification circuit 14. Incidentally, control of the frequency band can be actualized by some method that capacity (or capacitance) inserted into a feedback loop of a differential amplifier, provided inside of the receiving light amplification circuit 14, is changed over based on a control signal given from the control circuit 21, for example.

The control circuit 21 sets the sampling timing of the A/D conversion circuit 15 and the frequency band of the receiving light amplification circuit 14 in such a way that an output value of the A/D conversion circuit 15 becomes maximal. Thus, it is possible to maximize the synthesized amplification gain of the receiving light amplification circuit 14 and the A/D conversion circuit 15.

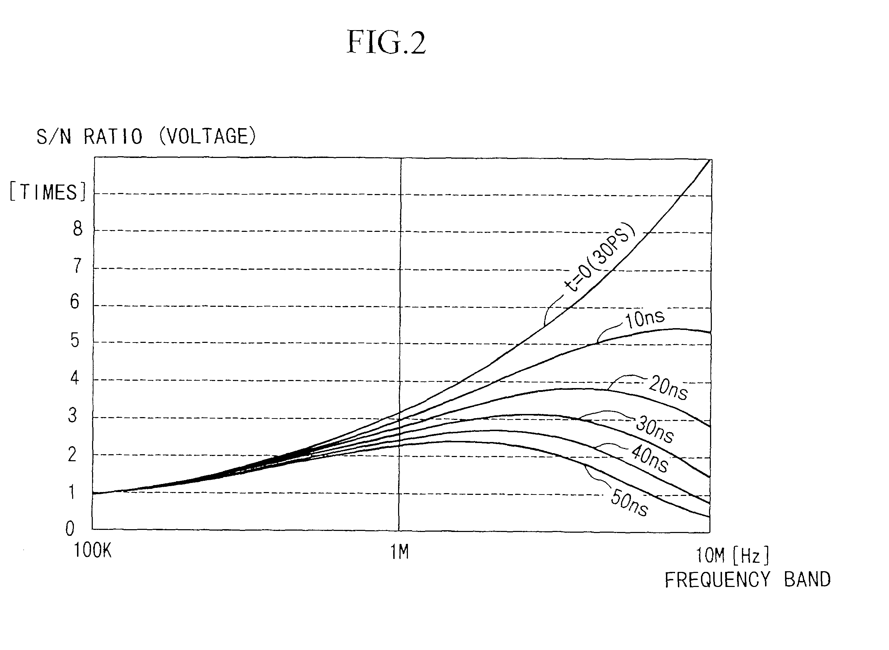

As described above, the present embodiment is designed to set the sampling timing and frequency band such that the output value of the A/D conversion circuit 15 becomes maximal. Instead, the sampling timing and frequency band can be set such that a S/N ratio becomes maximal. FIG. 2 is a graph showing curves representing relationships between S/N ratios in output of the AID conversion circuit 15 and the frequency bands of the receiving light amplification circuit 14, wherein there are provide six curves with respect to parameters corresponding to different sampling timings in analog-to-digital conversion. This graph shows that the S/N ratios are greatly differed from each other in response to the frequency bands of the receiving light amplification circuit 1 and the sampling timings of the A/D conversion circuit 15. Incidentally, the graph merely shows theoretical values, so actually measured values are differed from the theoretical values.

Therefore, it is possible to modify the present embodiment such that the control circuit 21 measures the S/N ratio of the output of the AID conversion circuit 15 instead of the output level of the A/D conversion circuit 15. In that modification, it is possible to set the frequency band of the receiving light amplification circuit 14 and the sampling timing of the AID conversion circuit 15 such that the measured S/N ratio becomes maximal. Incidentally, measurement of noise level can be made by measuring output of the A/D conversion circuit 15 under a state where the optical pulse generation circuit 12 is turned off.

Lastly, effects of the invention will be described as follows:

This invention can increase the amplification efficiency of the signal processing circuit for the electro-optic probe. In the case where the frequency band of the receiving light amplification circuit is greatly narrower than a range of frequency components of receiving light signals, it is possible to reproduce the signals correctly. Further, it is possible to detect absolute values by correcting the sampling timing using the reference signal which is known in advance.

As this invention may be embodied in several forms without departing from the spirit of essential characteristics thereof, the present embodiment is therefore illustrative and not restrictive, since the scope of the invention is defined by the appended claims rather than by the description preceding them, and all changes that fall within metes and bounds of the claims, or equivalence of such metes and bounds are therefore intended to be embraced by the claims.

## Claims

1. A signal processing circuit for an electro-optic probe, comprising:
amplification means for amplifying an output signal of the electro-optic probe;
analog-to-digital conversion means for performing sampling on output of the amplification means so as to convert it to digital data;
sampling timing detection means for sequentially changing sampling timings of the analog-to-digital conversion means so as to detect a sampling timing that an output value of the analog-to-digital conversion means becomes maximal; and
setting means for setting the sampling timing detected by the sampling timing detection means to the analog-to-digital conversion means.

2. A signal processing circuit for an electro-optic probe, comprising:
amplification means for amplifying an output signal of the electro-optic probe;
analog-to-digital conversion means for performing sampling on output of the amplification means so as to convert it to digital data;
frequency band detection means for sequentially changing frequency bands of the amplification means so as to detect a frequency band that an output value of the analog-to-digital conversion means becomes maximal; and
setting means for setting the frequency band detected by the frequency band detection means to the amplification means.

3. A signal processing circuit for an electro-optic probe, comprising:
amplification means for amplifying an output signal of the electro-optic probe;
analog-to-digital conversion means for performing sampling on output of the amplification means so as to convert it to digital data;
sampling timing detection means for sequentially changing sampling timings of the analog-to-digital conversion means so as to detect a sampling timing that a S/N ratio of output of the analog-to-digital conversion means becomes maximal; and
setting means for setting the sampling timing detected by the sampling timing detection means to the analog-to-digital conversion means.

4. A signal processing circuit for an electro-optic probe, comprising:
amplification means for amplifying an output signal of the electro-optic probe;
analog-to-digital conversion means for performing sampling on output of the amplification means so as to convert it to digital data;
frequency band detection means for sequentially changing frequency bands of the amplification means so as to detect a frequency band that a S/N ratio of output of the analog-to-digital conversion means becomes maximal; and
setting means for setting the frequency band detected by the frequency band detection means to the amplification means.

5. A signal processing circuit comprising:
laser beam generation means for generating a laser beam;
an electro-optic probe for introducing the laser beam therein when being brought into contact with a measured object, so that the electro-optic probe provides a reflected laser beam, based on which two laser beams are derived and are converted to electric signals respectively;
amplification means for performing differential amplification on the electric signals output from the electro-optic probe;
analog-to-digital conversion means for converting output of the amplification means to digital data;
sampling timing determination means for determining an optimum sampling timing such that output of the analog-to-digital conversion means becomes maximal, so that the optimum sampling timing is set to the analog-to-digital conversion means; and
frequency band determination means for determining an optimum frequency band such that the output of the analog-to-digital conversion means becomes maximal, so that the optimum frequency band is set to the amplification means.

6. A signal processing circuit according to claim 5, wherein the measured object corresponds to a printed-circuit board.
